# EUROPEAN PATENT APPLICATION

(11) **EP 4 588 887 A1**
(43) Date of publication of application: **23.07.2025**
(21) Application number: 22958840.5
(22) Date of filing: 16.09.2022
(51) Int. Cl.: B81B 5/00, B01J 19/00

(54) **MICROREACTOR**

(71) Applicant: M. Technique Co., Ltd., Izumi-shi, Osaka 594-1144 (JP)
(72) Inventor: ENOMURA Masakazu, Izumi-shi, Osaka 594-1144 (JP)
(74) Representative: Marks & Clerk LLP
(86) International application number: PCT/JP2022/034731
(87) International publication number: WO 2024/057520

(57) **Abstract**

A microreactor 10 according to this invention comprising an outer member **11** with a tapered inner peripheral surface 16b, an inner member 12 with a tapered outer peripheral surface 17c, a clearance adjusting unit 13 which enables adjustment of clearance distance L between the tapered inner peripheral surface 16b and the tapered outer peripheral surface 17c by relatively moving the outer member **11** and the inner member 12 in vertical direction; wherein a relative rotation between the outer member **11** and the inner member 12 is restricted, a flow path 40 is compartmentalized between the inner peripheral surface 16 of the outer member **11** and the outer peripheral surface 17 of the inner member 12, through which an object to be processed is circulating from below to above ,a region compartmentalized in the flow path by the tapered inner peripheral surface 16b and the tapered outer peripheral surface 17c functions as the processing region 40a processing the object to be processed, and an apex angles of the taper of the tapered inner peripheral surface 16b and the tapered outer peripheral surface 17c are set to the same angles each other, the apex angles are 5 degrees or more and 120 degrees or less.

## Description

### [Technical Field]

The present disclosure relates to microreactor which processes the fluid to be processed.

### [Background Art]

As the device for processing fluid, which uses a slight flow path or a slight reactor vessel, microreactor and micromixer are provided. A slight reaction field which is given in such devices, has possibility which may significantly affect chemical reaction itself which had executed in the previous beaker or flask.

However, in the general microreactor, solids or precipitates which are generated by reaction may stack in flow path, this may lead blockage of flow path. Moreover, due to high loss of pressure, high large pump is needed. In addition, due to impossibility of scaling up, the problem is continuing, which employment does not progress for a long time. That is, if these problems are solved, the microreactor can spread, this can lead to contribute to chemical industry including biochemistry, metal industry, food industry, ceramic industry, pigments industry, and pharmaceutical industry.

The processing device or processing method described in Patent Document 1 or Patent Document 2 which is proposed by present applicator, which perform such as reaction, crystallization, mixing, dissolving, and dispersing between planes for processing of sections for processing, where can approach, be estranged, and relatively rotate, enables to form the slight reaction field, and to further solve the problems above mentioned of the microreactor.

However, the fluid processing device such as described Patent Document 1 or Patent Document 2 comprises a rotating axis and rotates a ceramic disk. Therefore, cost is high. In addition, the structure will be complex, and the number of components will be also large. Therefore, the product with a simple structure with a low number of components is desired.

In the microreactor described in Patent Document 3, the objects to be processed are respectively introduced into the microchannel from the slit-shaped flow paths. The microchannel is the conical-shaped flow path, and the clearance thereof increases as getting near to the exit. Moreover, according to configuration of the introduction opening of the microreactor, easiness of introduction of objects to be processed is different depend on shape of introduction opening. For example, the entrainment largely works to the flow of the object to be processed in the third slit-shaped flow path due to the flow of object to be processed from the first slit-shaped flow path, on the other hand, opposite pressure occurs on the flow of object to be processed from the second flow path. This makes introduction of the object to be processed to be difficult, therefore setting of condition tend to be difficult. Therefore, doubt is remaining, though it is described in Patent Document 3 that the length of the microchannel does not have to be very long, and the time is not needed to complete reaction.

### [Prior Art Document]

### [Patent Document]

Patent Document 1: JP 2004-49957A
Patent Document 2: WO 2009/008394
Patent Document 3: JP 2007-319813A

### [Summary of the Invention]

### [Problems to be Solved by the Invention]

Therefore, this disclosure aims to provide a microreactor which enables to reduce the length of the flow path for the object to be processed and process time, of which structure is simple, of which number of components is low, and of which producing cost is reduced.

### [Means for Solving the Problems]

To solve above mentioned problems, the microreactor of the first aspect according to this invention comprising:
a tubular-shaped outer member comprising a tapered inner peripheral surface at least in one part region of an inner peripheral surface, the outer member being extending in the predetermined direction,
an inner member comprising a tapered outer peripheral surface facing to the tapered inner peripheral surface at least on one part region of an outer peripheral surface, the inner member being arranged inside of the outer member in diametrical direction, and
a clearance adjusting unit which enables adjustment of clearance distance between the tapered inner peripheral surface and the tapered outer peripheral surface by relatively moving the outer member and the inner member in the predetermined direction; wherein a relative rotation between the outer member and the inner member is restricted,
a flow path is compartmentalized between the inner peripheral surface of the outer member and the outer peripheral surface of the inner member, through which an object to be processed is circulating from one side of the predetermined direction to another side thereof,
a region compartmentalized in the flow path by the tapered inner peripheral surface and the tapered outer peripheral surface functions as the processing region processing the object to be processed, and
an apex angles of the tapers of the tapered inner peripheral surface and the tapered outer peripheral surface are set to be same angles each other, the apex angles are 5 degrees or more and 120 degrees or less.

The second aspect of this invention is the microreactor according to the first aspect;
wherein
the microreactor executes one process among reaction including biochemical reaction, crystallization, mixing, dissolving, and dispersing in the processing region of the flow path.

The third aspect of this invention is the microreactor according to the first aspect or the second aspect; wherein
the tapered inner peripheral surface and the tapered outer peripheral surface are tapered tapering off from another side of the predetermined direction to one side thereof.

The fourth aspect of this invention is the microreactor according to the first aspect or the second aspect; comprising
multiple inflow openings for the object to be processed allowing the inflow of the object to be processed into the flow path; wherein
the multiple inflow openings for the object to be processed are arranged in more upstream side than the processing region in the flow path, or arranged in the middle of the processing region.

The fifth aspect of this invention is the microreactor according to the fourth aspect;
wherein
the multiple inflow openings for the object to be processed are respectively connected to different pressure feeding systems.

The sixth aspect of this invention is the microreactor according to the first aspect or the second aspect; wherein
the clearance distance is 0.1µm or more and 3mm or less in using state in case of processing of the object to be processed

The seventh aspect of this invention is the microreactor according to the first aspect or the second aspect; wherein
the clearance adjusting unit comprises,
a fixing member for supporting the inner member so that the inner member can slide and move in the predetermined direction, the fixing member is fixed to the outer member, and
a differential screw for sliding and moving the inner member relative to the fixing member in the predetermined direction.

The eighth aspect of this invention is the microreactor according to the first aspect or the second aspect; wherein
the inner peripheral surface of the outer member and the outer peripheral surface of the inner member, which compartmentalize the flow path, do not have horizontal parts having possibility which the object to be processed circulating through the flow path may accumulate.

The ninth aspect of this invention is the microreactor according to the first aspect or the second aspect; wherein
at least one of the outer member and the inner member comprises a jacket through which another fluid can circulate, the another fluid is for temperature adjustment of the object to be processed circulating through the flow path.

The tenth aspect of this invention in the microreactor according to the first aspect or the second aspect; wherein
the inner peripheral surface of the outer member and the outer peripheral surface of the inner member, which compartmentalize the flow path, are coated with corrosion-resistant material.

The eleventh aspect of this invention is the method for use of the microreactor using the microreactor according to the sixth aspect; wherein
in case of adjusting the clearance distance to using state, contacting the tapered inner peripheral surface and the tapered outer peripheral surface thereafter, estranging the tapered outer peripheral surface toward the another side of the predetermined direction from the tapered inner peripheral surface to set to using state.

### [Effects of the Invention]

According to this disclosure, it is possible to provide the microreactor which enables to reduce the length of the flow path for the object to be processed and processing time, of which structure is simple, of which number of components is low, and of which producing cost is reduced.

### [Brief Description of the Drawings]

[FIG. 1] FIG. 1 is an axial cross-sectional view of the microreactor according to first embodiment of present invention.
[FIG.2] FIG.2 is a cross-sectional view with II-II arrowhead in FIG.1.
[FIG.3] FIG.3 is a cross-sectional view with III-III arrowhead in FIG.1.
[FIG.4] FIG.4 is a cross-sectional view with IV-IV arrowhead in FIG.1.
[FIG.5] FIG.5 is an explanatory diagram showing the configuration for using the microreactor.
[FIG.6A] FIG.6A is an explanatory diagram of the state of the microreactor, is showing the contacting state.
[FIG.6B] FIG.6B is an explanatory diagram of the state of the microreactor, is showing using state.
[FIG.6C] FIG.6C is an explanatory diagram of the state of the microreactor, is showing the estranged state.
[FIG. 7] FIG.7 is an axial cross-sectional view of the microreactor according to second embodiment of present invention.

### [Modes for Carrying Out the Invention]

Exemplary embodiments of this invention will be described with reference to drawings. Separately, in each of drawings, UP is indicating upwards. In addition, CL is indicating the central axis of the outer member and the inner member. In addition, in the following explanation, the axial direction means the direction along to the central axis CL of the outer member and the inner member. In addition, the diametrical direction means the direction perpendicular to the central axis CL. In addition, the hollow arrow in each figure is indicating the circulation direction of fluid to be processed. In addition, in the following explanation is explained assuming the axial direction (predetermined direction) as the vertical direction, with one side of the axial direction as the lower side, and the other side of the axial direction as upper side.

The microreactor is the device which can circulate the fluid which is an object to be processed (hereinafter, refer to "the fluid to be processed") into the slight flow path and perform the predetermined process (hereinafter, it may be simply referred to "process") and obtain the processed object. In the above process, the process is included, which is one of reactions including biochemical reaction, crystallization, mixing, dissolving, dispersing. That is, the microreactor also can be used as the micromixer mixing the fluid to be processed in slight flow path.

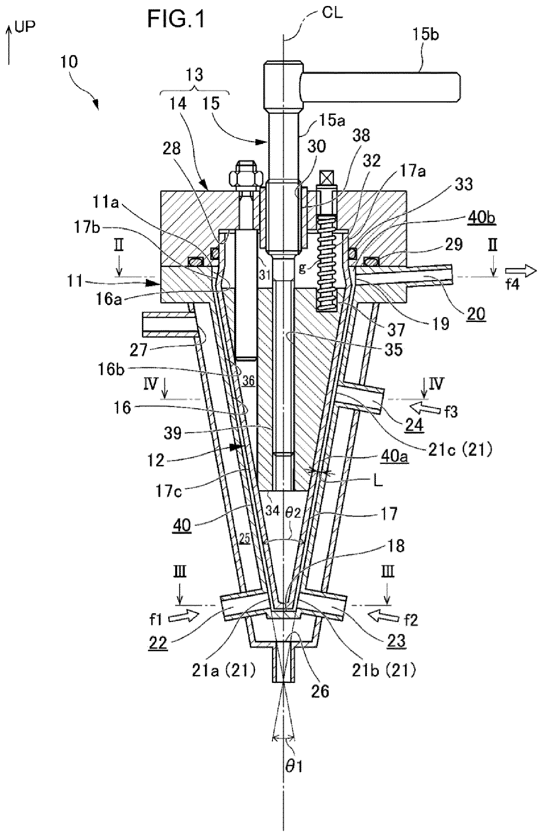

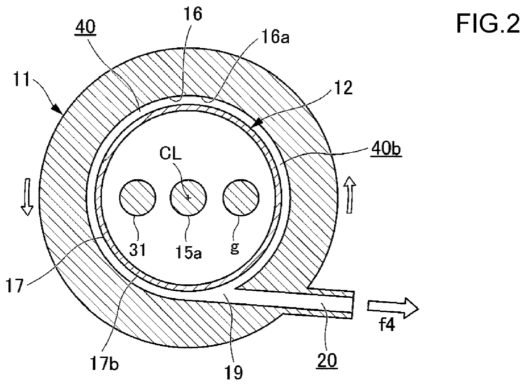

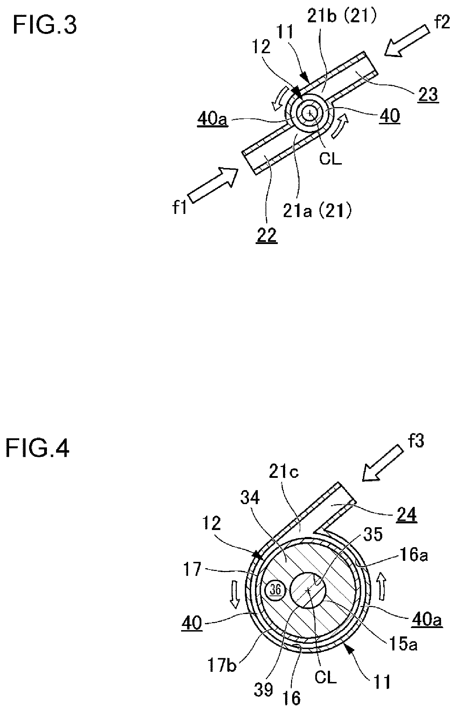

FIG. 1 is an axial cross-sectional view of the microreactor according to first embodiment of the present invention. FIG.2 is a cross-sectional view with II-II arrowhead in FIG.1. FIG.3 is a cross-sectional view with III-III arrowhead in FIG.1.FIG.4 is a cross-sectional view with IV-IV arrowhead in FIG.1.

As shown in FIG.1, the microreactor 10 according to first embodiment of present invention comprises an outer member 11 formed with the tubular-shape extending in the predetermined direction (in this embodiment, the vertical direction), an inner member 12 arranged inside in diametrical direction of the outer member 11, and a clearance adjusting unit 13 which can relatively move the outer member 11 and the inner member 12 in the vertical direction. The clearance adjusting unit 13 comprises a fixing member 14 fixed to the outer member 11, and a differential screw 15 attached to, the fixing member 14 and the inner member 12.

The outer member 11 and the inner member 12 are coaxially arranged so that the central axes CL thereof overlap each other. The gap (space) is provided between the inner periphery surface 16 of the outer member 11 and the outer periphery surface 17 of the inner member 12, this gap functions as a flow path 40 through which the fluid to be processed circulates. The flow path 40 allows the circulation of the fluid to be processed from below (the predetermined one side) to above (the predetermined another side). Separately, unless otherwise noted, the structure of the microreactor 10 is explained, which is in the state where process of the fluid to be processed can be executed (hereinafter, refer to "using state").

The outer member 11 is formed with tubular-shape (in this embodiment, the tubular-shape with bottom), of which central axis CL is extending in the predetermined direction (in this embodiment, the vertical direction). The outer member 11 comprises an upper end opening 11a on the upper end thereof, an inner peripheral surface 16 extending toward below from the upper end opening 11a, and a bottom plane 18. The upper end opening 11a is arranged so as to be concentric with the central axis CL. The upper end opening 11a functions as an insertion opening for inserting the inner member 12 toward inside of the outer member 11.

The inner peripheral surface 16 of outer member 11 compartmentalizes space (hereinafter, refer to "inner space") inside thereof. In this embodiment, the inner peripheral surface 16 comprises the inner peripheral surfaces with respectively different functions on the two different regions disposed in the vertical direction. The inner peripheral surface 16 with two different functions is, in order from above, an outflow part inner peripheral surface 16a, a tapered inner peripheral surface 16b. That is, the outer member 11 comprises the tapered inner peripheral surface 16b at least in one part region of the inner peripheral surface 16. The outflow part inner peripheral surface 16a and the tapered inner peripheral surface 16b in the outer member 11 compartmentalizes outside of the flow path 40. Separately, in this embodiment, the inner peripheral surface 16 of the outer member 11 is assumed as the inner peripheral surface 16 comprising the outflow part inner peripheral surface 16a and the tapered inner peripheral surface 16b, it is not limited to this, the inner peripheral surface 16 can be the inner peripheral surface 16 comprising the tapered inner peripheral surface 16b at least in one part region. For example, the inner peripheral surface 16 can be employed, which is configured with only the tapered inner peripheral surface 16b, or which comprises another region in addition to the outflow part inner peripheral surface 16a and a tapered inner peripheral surface 16b.

The outflow part inner peripheral surface 16a of the outer member 11 is extending toward below from the upper end opening 11a. The outflow part inner peripheral surface 16a in this embodiment is formed with tubular-shape. In the outflow part inner peripheral surface 16a, an outflow opening 19 is formed, the outflow opening 19 is for making the fluid to be processed to flow out from the flow path 40. The outflow part inner peripheral surface 16a compartmentalizes outside in diametrical direction of the space (an outflow region 40b described below) where the fluid to be processed before flowing out from the flow path 40 is existing. As shown in FIG.2, an outflow path 20 is extending from the outflow path 19, which is for making such as the fluid to be processed (including the processed object after process, same hereafter) to flow out from the flow path 40. The outflow path 20 is preferably extending along to the tangential direction of the cross section of the flow path 40 so as to make such as the fluid to be processed to flow out in the forward direction along to the circulation direction (in this embodiment, the counterclockwise direction in FIG.2) of such as the fluid to be processed which circulates through the flow path 40. In addition, the outflow path 20 is preferably inclined so that the outflow opening 19 side is lower. Separately, in this embodiment, the outflow path 20 is extending toward the tangential direction of the cross section of the circulation 40, however, it is not limited to this, the outflow path 20 can be extending toward optional direction. In addition, the outflow path 20 is inclined so that the outflow opening 40 side is lower, it is not limited to this, it is possible to set to optional angle. In addition, in this embodiment, the outflow opening 19 is provided at the outflow part inner peripheral surface 16a, however, the outflow opening 19 can be provided at the upper end part of tapered inner peripheral surface 16b in case of configurating the inner peripheral surface 16 of the outer member 11 with only the tapered peripheral surface 16b.

The tapered inner peripheral surface 16b is the inner peripheral surface formed with taper-shape (conical shape), is extending toward below from the lower end of the outflow part inner peripheral surface 16a. The tapered peripheral surface 16b in this embodiment is formed with taper-shape tapering off as getting downward from upward. The tapered peripheral surface 16b compartmentalizes outside in diametrical direction of space (a processing region 40a described below) where the fluid to be processed can be processed. The position being the apex of taper of the tapered inner peripheral surface 16b is situated on the central axis CL. The apex angle *θ*1 of taper of the tapered inner peripheral surface 16b is set to 5 degrees or more and 120 degrees or less. In this embodiment, the tapered inner peripheral surface 16b is extending across upper side and lower side with the predetermined angle (the apex angle *θ*1). Separately, the apex angle *θ*1 of taper of the tapered inner peripheral surface 16b is preferably 10 degrees or more and 90 degrees or less, further preferably 15 degrees or more and 55 degrees or less.

Multiple inflow openings (multiple inflow openings for fluid to be processed) 21 are formed on the tapered inner peripheral surface 16b of the outer member 11, which are for making the fluid to be processed flow in into the flow path 40. That is, the microreactor 10 comprises multiple (in this embodiment, three) inflow openings 21 allowing inflow of the fluid to be processed toward the flow path 40. In this embodiment, multiple openings 21 are provided in the middle of a processing region 40a described below of the flow path 40. In this embodiment, the multiple inflow openings 21 include a first inflow opening 21a and a second inflow opening 21b, which are formed on the lower end part of the tapered inner peripheral surface 16b, and a third inflow opening 21c formed on the middle part of the tapered inner peripheral surface 16b. Separately, the number of the multiple inflow openings (multiple inflow openings for fluid to be processed) 21 is not limited to three.

As shown in FIG.1 and FIG.3, the first inflow opening 21a and the second inflow opening 21b are arranged, on the lower end part of the tapered inner peripheral surface 16b, on the rotationally symmetrical positions, which become same positions each other when rotating 180 degrees around the central axis CL. A first inflow path 22 is extending from the first inflow opening 21a, the first inflow path 22 is for making the fluid to be processed flow in into the flow path 40. The first inflow path 22 is preferably extending along to the tangential direction of the cross section of the flow path 40 so as to make the fluid to be processed flow in in the forward direction along to the circulation direction (in this embodiment, the counterclockwise direction in FIG.3) of such as the fluid to be processed which circulates through the flow path 40. In addition, a second inflow path 23 is extending from the second inflow opening 21b, the second inflow path 23 is for making the fluid to be processed to flow in into the flow path 40. The second inflow path 23 is, same as the first inflow path 22, also preferably extending along to the tangential direction of the cross section of the flow path 40 so as to make the fluid to be processed flow in in forward direction along to the circulation direction (in this embodiment, the counterclockwise direction in FIG.3) of such as the fluid to be processed which circulates through the flow path 40. In addition, the first inflow path 22 and the second inflow path 23 are preferably inclined so that the first inflow opening 21a and the second inflow opening 21b is upper. Due to this, it is possible to spirally rotate and raise the fluid to be processed from the first inflow opening 21a and the second inflow opening 21b from lower side to upper side. Separately, in this embodiment, the first inflow path 22 and the second inflow path 23 is extending toward the tangential direction of the cross section of the flow path 40, it is not limited to this, it is possible to extend toward optional direction. In addition, in this embodiment, the first inflow path 22 and the second inflow path 23 are inclined so that the first inflow opening 21a side or the second inflow opening 21b side is upper, they are not limited to this, it is possible to set to optional angle.

As shown in FIG.1 and FIG.4, in this embodiment, the third inflow opening 21c is arranged upper than the first inflow opening 21a and the second inflow opening 21b in the tapered inner peripheral surface 16b. A third inflow path 24 is extending from the third inflow opening 21c, the third inflow path 24 is for making the fluid to be processed to flow in into the flow path 40. The third inflow path 24 is preferably extending along to the tangential direction of the cross section of the flow path 40 so as to make the fluid to be processed flow in in the forward direction along to the circulation direction (in this embodiment, the counterclockwise direction in FIG.4) of such as the fluid to be processed which circulates through the flow path 40. In addition, the third inflow path 24 is preferably inclined so that the third inflow opening 21c is upper. Due to this, it is possible to spirally rotate and raise such as the fluid to be processed from the third inflow opening 21c from lower side to upper side along to the flow from lower of such as the fluid to be processed from lower side. Separately, in this embodiment, the third inflow path 24 is extending toward the tangential direction of the cross section of the flow path 40, it is not limited to this, it is possible to extend toward optional direction. In addition, in this embodiment, the third inflow path 24 is inclined so that the third inflow opening 21c side is upper, it is not limited to this, it is possible to set to optional angle.

The bottom plane 18 of the outer member 11 compartmentalizes the lower side of the inner space of the outer member 11. In this embodiment, the bottom plane 18 is arranged with approximately same height as the lower edge of the first inflow opening 21a and the second inflow opening 21b. Separately, in FIG.1, the bottom plane 18 with plain-shape is shown, it is not limited to this, the bottom plane 18 can be inclined so that the fluid on the bottom plane 18 flows toward at least one direction of the first inflow opening 21a and the second inflow opening 21b.

As shown in FIG.1, a jacket 25 (space) can be provided in the outer member 11, which can circulate another fluid for the temperature adjustment of the fluid to be processed being in the flow path 40. For example, the jacket 25 is provided in outer side in diametrical direction than the flow path 40. A jacket inflow opening 26 is provided in the lower edge part of jacket 25, the jacket inflow opening 26 is for making another fluid to flow in into the jacket 25. A jacket outflow opening 27 is provided in the upper end part of the jacket 25, the jacket outflow opening 27 is for making another fluid to flow out from inside of jacket 25. As another fluid, for example, such as vapor, warm water, cool water, and gas (such as nitrogen gas) are conceivable. Separately, it is possible not to provide the jacket 25 in the outer member 11.

As shown in FIG.1, the fixing member 14 is formed more largely than an upper end opening 11a, and is arranged on the outer member 11, and is fixed (for example, fixed by fastening) to the outer member 11. The fixing member 14 blocks the upper end opening 11a of the outer member 11 in the state being fixed to the outer member 11. A supporting recessed part 28 recessed upward is formed. The bottom plane of the fixing member 14, where is outer than the supporting recessed part 28 in diametrical direction is facing to the top plane of the outer member 11, where is outer than the upper end opening 11a in diametrical direction. Between the lower plane of the fixing member 14 and the upper plane of the outer member 11, a first sealing member 29 (for example, O-ring) is provided between the lower plane of fixing member 14 and the upper plane of outer member 11 so as to surround the supporting recessed part 28 of fixing member 14 and the upper end opening 11a of outer member 11. That is, the first sealing member 29 seals between the lower plane of fixing member 14 and the upper plane of outer member 11.

The supporting recessed part 28 is arranged at a position with the central axis CL as the center, and the upper end part of the inner member 12 described below is inserted from lower side toward the supporting recessed part 28. The supporting recessed part 28 supports the upper end part of inserted inner member 12 so that the inner member 12 can be slid and moved in the vertical direction. That is, the fixing member 14 supports the inner member 12 so that the inner member 12 can slide and move, and the fixing member 14 is fixed to the outer member 11. A second sealing member 30(for example, O-ring) is provided across the entire peripheral region between the inner periphery surface of the supporting recessed part 28 and an outer periphery surface 17 of the inner member 12, the inner member 12 is to be inserted into the supporting recessed part 28.

In the predetermined position (in this embodiment, a position with the central axis CL as the center) of the fixing member 14, a through hole which goes through in vertical direction (axis direction), and interconnects between inner space of the supporting recessed part 28 and upper space of the fixing member 14. On the inner peripheral surface of the through hole, a female screw part 30 is formed. A pin 31 for stopping rotation which is extending along to the axis direction, is fixed to the different position from that of the through hole for the female screw part 30 on the lower plane inside of the supporting recessed part 28 (the bottom plane of the supporting recessed part 28) of the fixing member 14. The pin 31 is attachable and detachable toward the fixing member 14, in the state being fixed to the fixing member 14, is extending toward lower side along to axis direction from the lower plane inside of supporting recessed part 28 of the fixing member 14. A spring 32 which stops movement of the inner member 12 due to backlash of the differential screw 15 described below is fixed to the different position from that of the through hole of female screw 30 and pin 31 on the lower plane inside of the supporting recessed part 28 of the fixing member 14. The spring 32 is a spiral spring extending in the vertical direction, can elastically transform in the vertical direction. In addition, the spring 32 is restricted from transform in the direction crossing with the vertical direction. For example, inside of the spring 32 in diametrical direction, a guiding axis g for guidance is inserted, this guiding axis g restricts the transformation of the spring 32 in the direction crossing with the vertical direction. Separately, in FIG.1, one pin 31 is shown, however, the number of the pin 31 provided is not limited to one, multiple pins 31 can be provided. In addition, in FIG.1, one spring 32 is shown, however, the number of the spring 32 provided is not limited to one, multiple springs 32 can be provided.

As shown in FIG.1-FIG.4, the inner member 12 is arranged inside (inner space of the outer member 11) of the outer member 11 in diametrical direction, is supported to the fixing member 14 so that the inner member 12 can be slid and moved. That is, the inner member 12 can relatively move in the vertical direction (axial direction) relative to the outer member 11 via the fixing member 14. In this embodiment, the inner member 12 is inserted into the inner space of the outer member 11 from the upper end opening 11a of the outer member 11 in the state being supported by the fixing member 14. The inner member 12 comprises an outer peripheral surface 17 compartmentalizing the flow path 40 between the inner peripheral surface 16 of the outer member 11.

The inner member 12 of this embodiment is formed with the bottomed tubular-shape which opens upward. In the inner space of the inner member 12, a supported part 34 supported to the differential screw 15 is provided. In the supported part 34, the through hole having same axis as the female screw part 30 of the fixing member 14 is formed, in the inner peripheral surface of the through hole, a female screw part 35 is formed. The diameter of the female screw part 35 of this embodiment is smaller than the diameter of the through hole of the female screw part 30 of the fixing member 14. The pitch of the crests of the female screw part 35 in the supported member 34 is set to be shorter than the pitch of the crests of the female screw part 30 in the fixing member 14. For example, the pitch of the crests of the female screw part 35 in the supported member 34 is set to 1.8mm while the pitch of the crests of the female screw part 30 in the fixing member 14 is set to 2.0mm. In addition, in the supported part 34, a pin insertion hole 36 is formed, through which the pin 31 of the fixing member 14 is inserted. In addition, the pin 31 which is inserted into the pin insertion hole 36 allows the movement in the axial direction of the inner member 12 relative to the fixing member 14 and restricts the rotation of the inner member 12 relative to the fixing member 14. That is, in this embodiment, the relative rotation between the outer member 11 and the inner member 12 is restricted by the pin 31 which is inserted into the pin insertion hole 36 of the fixing member 14. In addition, the supported part 34 comprises a spring supporting part 37 supporting the tip (the lower end) of the spring 32. The spring 32 in the state being supported by the spring supporting part 37 is transforming and shrinking in the vertical direction, the spring 32 is energizing the inner member 12 toward below from the fixing member 14 side. Separately, the inner space of the inner member 12 may function as the jacket enabling to circulate another fluid for the temperature adjustment of the fluid to be processed in the flow path 40. In this case, another fluid to circulate in the jacket (the inner space) of the inner member 12 can be the same fluid as another fluid to circulate in the jacket 25 of the outer member 11 or can be different fluid.

The outer peripheral surface 17 of the inner member 12 is an outer peripheral surface compartmentalizing inside in diametrical direction of the flow path 40. **In** this embodiment, the outer peripheral surface 17 comprises outer peripheral surfaces having respectively different functions in three different regions disposed in the vertical direction. The outer peripheral surface 17 of the inner member 12, which is with three different functions, comprises a seal part outer peripheral surface 17a, an outflow part outer peripheral surface 17b, and a tapered outer peripheral surface 17c in order from above. That is, the inner member 12 comprises the tapered outer peripheral surface 17c at least in one part region of the outer peripheral surface 17. The outflow part outer peripheral surface 17b and the tapered outer peripheral surface 17c of the inner member 12 compartmentalizes inside in diametrical direction of the flow path 40. Separately, in this embodiment, the outer peripheral surface 17 of the inner member 11 is assumed as the outer peripheral surface 17 comprising the seal part outer peripheral surface 17a, the outflow part outer peripheral surface 17b, and the tapered outer peripheral surface 17c, it is not limited to this, the outer peripheral surface 17 should comprise the tapered outer peripheral surface 17c at least in one part region thereof. For example, the outer peripheral surface 17 of the inner member 12 can be the outer peripheral surface 17 being configured with only the tapered outer peripheral surface 17c or can be the outer peripheral surface 17 comprising another region in addition to the seal part outer peripheral surface 17a, the outflow part outer peripheral surface 17b, and the tapered outer peripheral surface 17c.

The seal part outer peripheral surface 17a of the inner member 12 is the outer peripheral surface being situated upper than the flow path 40 and is provided in the upper end part of the inner member 12. The seal part outer peripheral surface 17a of this embodiment is formed with the cylindrical shape extending toward the vertical direction. The seal part outer peripheral surface 17a is formed so that diameter thereof is slightly smaller than the inner peripheral surface of the supporting recessed part 28 in the fixing member 14 and is facing to the inner peripheral surface of the supporting recessed part 28. That is, the seal part outer peripheral surface 17a do not compartmentalize the flow path 40. The second seal member 33 seals between the seal part outer peripheral surface 17a and the inner peripheral surface of the supporting recessed part 28.

The outflow part outer peripheral surface 17b of the inner member 12 is extending toward below from the lower end of the seal part outer peripheral surface 17a. The outflow part outer peripheral surface 17b in this embodiment is formed with taper shape of which diameter widens from above to below. The outflow part outer peripheral surface 17b is arranged in the position estranged toward inside in diametrical direction from the outflow part inner peripheral surface 16a in the outer member 11 and is facing to the outflow part inner peripheral surface 16a. The outflow part outer peripheral surface 17b compartmentalizes space (an outflow region 40b described below) between the outflow part inner peripheral surface 16a. The estrangement distance between the outflow part outer peripheral surface 17b of the inner member 12 and the outflow part inner peripheral surface 16a of the outer member 11 is set to be larger than the estrangement distance L (hereinafter, it may simply be referred to "clearance distance L") between the tapered outer peripheral surface 17c of the inner member 12 and the tapered inner peripheral surface 16b of the outer member 11.

The tapered outer peripheral surface 17c of the inner member 12 is the outer peripheral surface formed with the taper-shape (cylindrical shape), which is extending toward below from the lower end of the outflow part outer peripheral surface 17b. The tapered outer peripheral surface 17c is facing to the tapered inner peripheral surface 16b in the state being estranged toward inside in diametrical direction from the tapered inner peripheral surface 16b of the outer member 11. In this embodiment, the tapered outer peripheral surface 17c is formed with the taper-shape tapering off as getting downward from upward. Between the tapered outer peripheral surface 17c and the taper-shaper inner peripheral surface 16b, the space (the processing region described below) where the fluid to be processed can be processed, is compartmentalized. That is, the tapered inner peripheral surface 16b compartmentalizes outside in diametrical direction of the processing region 40 which the fluid to be processed can be processed. The inner member 12 of this embodiment is formed so that the apex part side (the tip side) of the taper angle of the tapered outer peripheral surface 17c is situated at the lower end of the inner member 12. The position (illustration omitted) being the apex part of the taper angle of the tapered outer peripheral surface 17c is situated on the central axis CL. The apex angle *θ*2 of taper of the tapered outer peripheral surface 17c is same as the apex angle *θ*1 of taper of the tapered inner peripheral surface 16b and is set to 5 degrees or more and 120 degrees or less. In the embodiment, the tapered outer peripheral surface 17c is extending across above and below with the constant angle (the apex angle *θ*2). In this way, the apex angles *θ*1 and *θ*2 of the tapered inner peripheral surface 16b and the tapered outer peripheral surface 17c are set to the same angles each other of 5 degrees or more and 120 or less. Separately, the apex angle *θ*2 of the taper of the tapered outer peripheral surface 17c is preferably 10 degrees or more and 90 degrees or less, more preferably 15 degrees or more and 55 degrees or less, same as the apex angle *θ*1 of the taper of the tapered inner peripheral surface 16b.

As shown in FIG.1, the differential screw 15 of the clearance adjusting unit 13 is the member that slides and moves the inner member 12 in the vertical direction relative to the fixing member 14, thereby enabling to adjust the clearance distance L between the tapered inner peripheral surface 16b and the tapered outer peripheral surface 17c. That is, the clearance adjusting unit 13 comprising the fixing member 14 and the differential screw 15 relatively moves the outer member 11 and the inner member 12 in the vertical direction, thereby enabling to adjust the clearance distance L between the tapered inner peripheral surface 16b and the tapered outer peripheral surface 17c. The differential screw 15 integrally comprises an axis part 15a and a handle part 15b.

The axis part 15a of the differential screw 15 is extending in the linear shape in axial direction and is inserted into the through hole, where the female screw part 30 of the fixing member 14 is formed, and the through hole where the female screw part 35 of the inner member 12 is formed. The upper end of the axis part 15a is projecting upward from the fixing member 14. The axis part 15a comprises a first male screw part 38 screwing with the female screw part 30 of the fixing member 14, a second male screw part 39 screwing with the female screw part 35 of the inner member 12. In this embodiment, the first male screw part 38 is formed with the larger diameter than the second male screw part 39. The pitch of the threads of the first screw part 38 is set to be larger that the pitch of the threads of the second male screw part 39. For example, the pitch of the thread of the first male screw part 38 is set to 2.0mm, while the pitch of the thread of the second male screw part 39 is set to 1.8mm. That is, while one rotation of the differential screw 15, the inner member 12 slides and moves 0.2mm in the axial direction relative to the outer member 11. Separately, in this embodiment, the female screw part 35 is provided in the supported part 34 of the inner member 12, while the second male screw part 35 is provided in the differential screw 15, it is not limited to this. For example, instead of the female screw part 35, the male screw part can be provided in the supported part 34 of the inner member 12, while the female screw part screwing with the male screw part can be provided in the differential screw 15, instead of the second male screw part 39.

The handle part 15b of the differential screw 15 is the operational part of the differential screw 15, is extending toward outside in diametrical direction from the upper end part of the axial part 15a. The user holds the handle part 15b and rotate the axial part 15a, thereby the inner member 12 can be slid and moved in the axial direction relative to the outer member 11.

In case of assembling the microreactor 10 of this embodiment, at first, assembling the differential screw 15 and the inner member 12 into the fixing member 14. Next, inserting the inner member 12 which had been assembled with the fixing member 14 into the inner space of the outer member 11 from the upper end opening 11a of the outer member 11, and fixing the fixing member 14 to the outer member 11. Therefore, it is possible to assemble the outer member 11, the fixing member 14, the inner member 12, and the differential screw 15 each other, thereby assembling the microreactor 10. In addition, in case of assembling the microreactor 10, it is possible to adjust the clearance distance L between the tapered outer peripheral surface 17c and the tapered inner peripheral surface 16b. The adjustment of the clearance distance L is described below. Separately, how to assemble the microreactor 10 is not limited to above.

Next, the flow path 40 compartmentalized between the inner peripheral surface 16 of the outer member 11 and the outer peripheral surface 17 of the inner member 11 will be explained.

As shown in FIG. 1, in the state that the microreactor 10 has been assembled, between the inner peripheral surface 16 of the outer member 11 and the outer peripheral surface 17 of the inner member 12, the flow path 40 is compartmentalized, which allows the circulation of the fluid to be processed from below to above. The flow path 40 in this embodiment comprises two regions. The two regions of the flow path 40 are a processing region 40a and an outflow region 40b in order from lower.

The processing region 40a of flow path 40 with slight clearance distance L is a microchannel where fluid to be processed can be processed, is compartmentalized between the tapered outer peripheral surface 17c of the inner member 12 and the tapered inner peripheral surface 16b of the outer member 11. The diameter of the cross section being perpendicular to the axial direction of the processing region 40 of this embodiment is increasing as getting upper from lower (see FIG,3 and FIG.4). **In** addition, the clearance distance L of the processing region 40a of this embodiment is constant across from the lower side to the upper side. The first inflow opening 21a and the second inflow opening 21b are communicating with the lower end part of the processing region 40a, where the fluid to be processed which had pressure fed by the pressure feeding system S1, S2 described below flows in. In addition, the third inflow opening 21c is communicating with the middle part between the upper and the lower ends of the processing region 40a, where the fluid to be processed which had pressure fed by the pressure feeding system S3 described below flows in.

The clearance distance L of the processing region 40a in using state of the microreactor 10 is preferably 0.1µm or more and 3mm or less. Setting of the clearance distance L within the range leads to effectively process the fluid to be processed.

The outflow region 40b of the flow path 40 is space through which such as the fluid to be processed passed through the processing region 40a flows in, is compartmentalized between the outflow part inner peripheral surface 16a of the outer member 11 and the outflow part outer peripheral surface 17b of the inner member 12. The outflow region 40b is situated in above of the processing region 40a and is communicating with the processing region 40a, and upper thereof is compartmentalized by the bottom plane of the fixing member 14. The estrangement distance between the outflow part inner peripheral surface 16a and the outflow part outer peripheral surface 17b in the outflow region 40b is set to be larger than the clearance distance L of the processing region 40a. The outflow opening 19 of the outer member 11 is communicating with the outflow region 40b, the processed object processed by the microreactor 10 flows out toward outside from the outflow region 40b via the outflow opening 19 and the outflow path 20.

The inner peripheral surface 16 of the outer member 11 and the outer peripheral surface 17 of the inner member 12, which compartmentalizes the flow path 40, in the state that the axial direction is assumed as the vertical direction, do not have the horizontal sections having possibility which such as the fluid to be processed circulating the flow path 40 may accumulate. Specifically, the outflow part inner peripheral surface 16a, tapered inner peripheral surface 16b, the outflow part outer peripheral surface 17b of the inner member 12, and the tapered outer peripheral surface 17c, do not have top planes which are horizontal in the state that axial direction is assumed as the vertical direction.

As material of the inner peripheral place 16 of outer member 11 and the outer peripheral surface 17 of inner member 12, such as metal can be properly selected according to the kind of the fluid to be processed. For example, the material can be SUS316L buffed and then electropolished. In addition, in the inner peripheral surface 16 of the outer member 11 and the outer peripheral surface 17 of the inner member 12, the region where compartmentalizes the processing region 40a is preferably made with ceramics such as silicon carbide, tungsten carbide, alumina, to prevent such as seizure. However, such as diamond-like carbon can be substituted. In addition, the inner peripheral surface 16 of the outer member 11 and the outer peripheral surface 17 of the inner member 12, which is compartmentalizing the flow path 40, is preferably coated with the corrosion-resistant material. As coating by the corrosion-resistant material, glass lining or fluoropolymer coating and ceramic coating can be exemplified, fluoropolymer coating is more preferred.

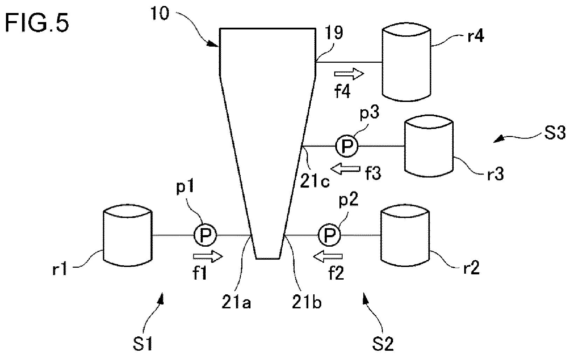

Next, flow of the fluid to be processed in case of executing process in the microreactor 10 will be explained. FIG.5 is an explanatory diagram showing the configuration for use of the microreactor 10.

As show in FIG.5, the microreactor 10 is connected to multiple pressure feeding systems for pressure feeding the fluid to be processed toward the flow path 40. For example, the multiple pressure feeding systems comprise a first pressure feeding system S1 to be connected to the first inflow opening 21a of the outer member 11, a second pressure feeding system S2 to be connected to the second inflow opening 21b, and a third pressure feeding system S3 to be connected to the third inflow opening 21c. That is, the multiple inflow openings 21 of this embodiment are respectively connected to each of the different pressure feeding systems. Each of the pressure feeding systems S1, S2, S3 comprise the storage containers r1, r2, r3 storing the fluid to be processed, and pumps p1, p2, p3 pressure feeding the fluid to be processed toward the flow path 40, respectively. In addition, a storage container r4 storing the processed object is connected to the outflow opening 19 of the outer member 11. Separately, the configurations of the pressure feeding systems S1, S2, S3 are not limited to these, for example, another device such as flowmeter can be provided.

As shown with hollow arrows f1, f2 in FIG.1 and FIG.5, the fluid to be processed are, at first, pressure fed from the pressure feeding systems S1, S2, then flow in into the flow path 40 from the first inflow opening 21a and the second inflow opening 21b in the lower part of the outer member 11 of the microreactor 10 along to the predetermined rotating direction (in this embodiment, the counterclockwise direction from the top view). The fluid to be processed which had been flowed into the flow path 40 from the first inflow opening 21a and the second inflow opening 21b merge together, then forming spiral flow ascending processing region 40a along to the tapered inner peripheral surface 16b and the tapered outer peripheral surface 17c while rotating in the predetermined rotating direction around surroundings of the inner member 12. In this way, the fluid to be processed which had been flowed into the flow path 40 from the first inflow opening 21a and the second inflow opening 21b merge together, then the fluid to be processed is processed while ascending the processing region 40a with rotating, where is slight flow path.

In addition, as shown with the hollow arrow f3 in FIG.1 and FIG.5, the fluid to be processed is pressure fed from the pressure feeding systems S3 then flows in into the flow path 40 from the third inflow opening 21c in the middle part of the outer member 11 of the microreactor 10 along to the predetermined rotating direction. The fluid to be processed which had been flowed into the flow path 40 from the third inflow opening 21c merge with such as the fluid to be processed with spiral flow which had been ascended from the first inflow opening 21a and the second inflow opening 21b side, which are lower, then ascending the processing region 40a along to the tapered inner peripheral surface 16b the tapered outer peripheral surface 17c while rotating in the predetermined rotating direction around surroundings of inner member 12. In this way, the fluid to be processed which had been flowed into the flow path 40 from the third inflow opening 21c merge with such as the fluid to be processed from the first inflow opening 21a and the second inflow opening 21b, then the fluid to be processed is processed while ascending the processing region 40a with rotating. Such as the fluid to be processed which had been processed in the processing region 40a flows in into the upper outflow region 40b from the processing region 40a. As shown with the hollow arrow f4 in FIG.1 and FIG.5, such as the fluid to be processed which had been flowed in into the outflow region 40b flows out toward outside of the microreactor 10 from the outflow opening 19 of the outflow region 40b as processed object, then is stored in the storage container r4.

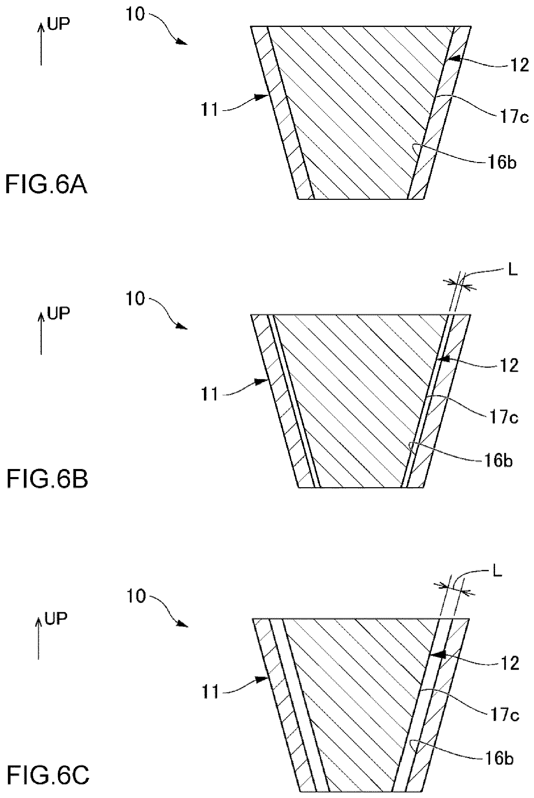

Next, how to use in case of using the microreactor 10 will be explained. FIG.6s are the explanatory diagrams of each state of the microreactor, FIG.6A is showing contacting state, FIG.6B is showing using state, FIG. 6C is showing estranged state. Separately, method for use of the microreactor 10 is not limited to below.

Firstly, method for use in case of setting the microreactor 10 to using state by adjusting the clearance distance L of the processing region 40a of the flow path 40 will be explained. Then method for use in case of washing or sterilization will be explained.

In case of adjusting the clearance distance L of the processing region of the flow path 40 to using state, firstly, rotating the differential screw 15 to slide and move the inner member 12 relative to the outer member 11 toward below along to the axial direction. This leads contacting state (the clearance distance L=0) where the tapered outer peripheral surface 17c of the inner member 12 and the tapered inner peripheral surface 16b of the outer member 11 is contacting (see FIG.6A). Next, rotating the differential screw 15 in the opposite direction to the case of setting contacting state, estranging the tapered outer peripheral surface 17c of the inner member 12 and the tapered inner peripheral surface 16b of the outer member 11 to set the clearance distance L, thereby using state is set (see FIG.6B). In this way, in case of setting to using state, estranging the tapered outer peripheral surface 17c and the tapered inner peripheral surface 16b from the contacting state, thereby the slight adjustment of the clearance distance L is well performed, unlike the case of adjusting in the direction which making the tapered outer peripheral surface 17c and the tapered inner peripheral surface 16b to approach, it is possible to set the microreactor 10 to the desired clearance distance L and set the microreactor 10 to using state. The rotation volume (rotation angle) of the differential screw 15 at this time can be easily calculated from the desired clearance distance L, the pitch of the threads of the first male screw part 38 (the female screw part 30 of the fixing member 14) of the differential screw 15, and the pitch of the threads of the second male screw part 39 (the female screw part 35 of the inner member 12). Specifically, the differential between the pitch of the threads of the first male screw part 38 of the differential screw 15 and the pitch of the threads of the second male screw part 39 is the moving distance of the inner member 12 relative to the outer member 11 in case of one-time rotation (360 degrees rotation) of the differential screw 15. Because of this, it is possible to calculate the rotation volume (the rotation angle) of the differential screw 15 from the movement distance in case of one-time rotation and the desired clearance distance L.

In using state, the rotation of the inner member 12 relative to the outer member 11 is restricted by the pin 31 inserted into the pin insertion hole 36, moreover, the movement in diametric direction of the inner member 12 relative to the outer member 11 is also restricted.

In case of washing or sterilization the microreactor 10, further rotating the differential screw 15 from using state, setting the clearance distance L to the estranged state where the clearance distance L is further estranged than using state (see FIG.6C). Due to this, it is possible to estrange the tapered inner peripheral surface 16b and the tapered outer peripheral surface 17c than those in using state and set the flow path (the flow path for making turbulent flow) enabling washing or sterilization, thereby it is possible to perform stationary washing and stationary sterilization without disassembling the microreactor 10.

In this way, in the microreactor 10, it is possible to set contacting state (see FIG.6A) where the tapered outer peripheral surface 17c and the tapered inner peripheral surface 16b are contacting, by rotating the differential screw 15. In addition, it is possible to set using state (see FIG.6B) where the clearance distance L is short in case of using the microreactor 10, by rotating the differential screw 15. In addition, it is possible to set the estranged state (see FIG.6C) where the clearance distance L is estranged further than using state, by further rotating the differential screw 15 from using state. That is, in the microreactor 10 according to this embodiment, it is possible to selectively set one of contacting state, using state, and estranged state, without disassembling the outer member 11 and the inner member 12.

In the microreactor 10 configured as above, the relative rotation between the outer member 11 and the inner member 12 is restricted, the predetermined process is executed to the fluid to be processed by rotating the fluid to be processed in the determined direction and raising in the processing region 40a. That is, the predetermined process of the fluid to be processed is executed without relatively rotating the outer member 11 and the inner member 12. Therefore, it is not needed to provide the configuration for relatively rotating the outer member 11 and the inner member 12, it is possible to restrict the number of the components of the microreactor 10, this leads to the simple structure thereof and to restrict the production cost.

In addition, the clearance adjusting unit 13 is provided, which can relatively move the outer member 11 and the inner member 12 in the vertical direction to adjust the clearance distance L, it is possible to set the slight flow path (the flow path making the laminar flow) where the process of the fluid to be processed can be effectively executed.

In addition, the clearance adjusting unit 13 enabling to adjust the clearance distance L is provided, therefore, it is possible to control the balance between the circumferential direction and the axial direction of the path for the fluid to be processed circulating in the flow path 40 by adjusting the clearance distance L, it is possible to change the length (the distance of the reaction field) of the path for the fluid to be processed. For example, in case of large clearance distance L, it is difficult for the spiral flow to occur, and it tends to be the upward flow. In case that the clearance distance L is small, the spiral flow occurs. As for this spiral flow, the smaller the clearance distance L is getting, the shorter the volume of upward movement in case of one-time rotation of the fluid to be processed is getting. Due to this, adjustment of the clearance distance L by the clearance adjusting unit 13 enables to restrict the length of the flow path 40 and the processing time of the fluid to be processed as a result, it is possible to obtain the processed object by simple structure with restricting cost.

In addition, the apex angle *θ*1, *θ*2 of the tapers of the tapered inner peripheral surface 16b and the tapered outer peripheral surface 17c are set to same angles each other. In this way, because the apex angles *θ*1, *θ*2 of tapers of the tapered inner peripheral surface 16b and the tapered outer peripheral surface 17c are same, the clearance distance L is constant across from the upper end to the lower end in the processing region 40a. Due to this, it is possible to properly set the clearance distance L and to effectively apply the power to the fluid to be processed.

In addition, both the apex angles *θ*1, *θ*2 of tapers of the tapered inner peripheral surface 16b and the tapered outer peripheral surface 17c are set to same angles of 5 degrees or more and 120 degrees or less. In case that both apex angles *θ*1, *θ*2 of tapers of the tapered inner peripheral surface 16b and the tapered outer peripheral surface 17c are set to smaller than 5 degrees, it is remarkably difficult to control the spiral flow, and it is difficult to ensure the processing volume. On the other hand, if both apex angles *θ*1, *θ*2 of tapers of the tapered inner peripheral surface 16b and the tapered outer peripheral surface 17c are set to larger than 120 degrees, enlargement of flow path 40 (processing region 40a) becomes drastic and cavitation is likely to occur. In addition, in case that both apex angles *θ*1, *θ*2 of tapers of the tapered inner peripheral surface 16b and the tapered outer peripheral surface 17c are set to 10 degrees or more and 90 degrees or less, the problems is mitigated, which are the reduction of the processing volume and occurrence of cavitation above mentioned, however, the fluid to be processed (the object to be processed) which can correspond is limited. In addition, in case that both apex angles *θ*1, *θ*2 of tapers of the tapered inner peripheral surface 16b and the tapered outer peripheral surface 17c are set to 15 degrees or more and 55 degrees of less, it is possible to solve the problems which are such as reduction of the processing volume, occurrence of cavitation, and the object to be processed which can correspond.

In this way, according to this embodiment, it is possible to restrict the length of the flow path 40 for the fluid to be processed (the object to be processed) and processing time, and it is possible to provide the microreactor 10 of which structure is simple, and of which number of the components is low, and which can restrict production cost.

In addition, in the processing region 40a of the flow path 40, the process at least one of reaction including biochemical reaction, crystallization, mixing, dissolving, dispersing can be performed. Therefore, various processes can be executed by the microreactor 10.

In addition, the tapered inner peripheral surface 16b and the tapered outer peripheral surface 17c are taper-shape tapering off from the upper side to the lower side, thereby the diameter of the processing region 40a of the flow path 40 is expanding toward the lower-stream side (the upper side) from the upper-stream side (the lower side). In this way, the diameter of the processing region 40a of the flow path 40 is expanding as getting to upper side and the flow path is gradually getting longer in the circumference direction, thereby the flow of the fluid to be processed circulating the processing region 40a further easily becomes to be circumferential.

In addition, setting of the clearance distance L to 0.1µm or more and 3mm or less enables to set the slight flow path where the process of the fluid to be processed can be effectively executed.

In addition, the first inflow opening 21a and the second inflow opening 21b in the multiple inflow openings 21 are arranged in the lower end part of the processing region 40a of the flow path 40, while the third inflow opening 21c is arranged in the middle part of the processing region 40a, where is upper than the first inflow opening 21a and the second inflow opening 21b. In this way, the third inflow opening 21c is arranged on position where estranged upper from the first inflow opening 21a and the second inflow opening 21b, in case of inflow of the fluid to be processed from the first inflow opening 21a and the second inflow opening 21b, it is possible to restrict the influence of the fluid to be processed flowing from the third inflow opening 21c.

In addition, the first inflow path 22, the second inflow path 23, and the third inflow path 24 are extended in the tangential direction of the cross section of the flow path 40, thereby it is easily possible to make the fluid to be processed to flow in into the flow path 40 along to the flow direction in the flow path 40 from the first inflow opening 21a, the second inflow opening 21b, and the third inflow opening 21c.

In addition, extending the outflow path 20 toward the tangential direction of the cross section of the flow path 40 enables to easily make the processed object to flow out from the outflow opening 19 along to the flow direction in the flow path 40.

In addition, the multiple inflow openings 21 are connected to the respectively different pressure feeding systems, it is possible to properly set such as the pressure of each pressure feeding system, and properly adjust the flow of the fluid to be processed being in the flow path 40. Therefore, it is possible to effectively process the fluid to be processed and obtain the processed object.

In addition, the processing region 40a of the flow path 40 is compartmentalized by the tapered inner peripheral surface 16b and the tapered peripheral surface 17c. Therefore, unlike the case where one of planes is not with the taper shape (for example, cylindrical plane extending along axial direction), the clearance distance L can be adjusted by relatively moving the outer member 11 and the inner member 12 in the axial direction.

In addition, the clearance distance L is adjusted by the differential screw 15, thereby the slight adjustment of the clearance distance L is easily executed. Due to this, it is possible to properly set the clearance distance L, thereby it is possible to set the slight flow path where the process of the fluid to be processed can be effectively executed.

In addition, the spring 32 is provided, which restricts the movement of the inner member 12 by the backlash of the differential screw 15. Therefore, it is possible to keep the axial position of the inner member 12 relative to the outer member 11 with stability.

In addition, the inner peripheral surface 16 of the outer member 11 and the outer peripheral surface 17 of the inner member 12, where compartmentalizes the flow path 40, do not have the horizontal planes having possibility which the fluid to be processed circulating the flow path 40 may accumulate in the state that the axial direction (the predetermined direction) is assumed as the vertical direction. Due to this, for example, residual of the cleaning agent (such as condensed water of the pure water) in case of washing the inner peripheral surface 16 of the outer member 11 and the outer peripheral surface 17 of the inner member 12, and such as precipitates in case that the fluid to be processed was processed, is prevented.

In addition, in case that the jacket (in this embodiment, jacket 25) is provided at least in one of the outer member 11 and the inner member 12, where another fluid for the temperature adjustment of the fluid to be processed circulating flow path 40 can circulate, it is possible to properly adjust the temperature of the fluid to be processed circulating the flow path 40. Due to this, it is possible to effectively process the fluid to be processed and obtain the processed object.

In addition, the first sealing member 29 seals between the lower plane of the fixing member 14 and the upper plane of the outer member 11. Due to this, it can be prevented, which is contamination of such as powder dust into the flow path 40 from between the lower plane of the fixing member 14 and the upper plane of the outer member 11.

In addition, the second sealing member 33 is provided across the entire peripheral region between the inner peripheral surface of the supporting recessed part 28 in the fixing member 14 and the outer peripheral surface17 in the upper end part of the inner member 12 inserted into the supporting recessed part 28. Due to this, it can be prevented, which is contamination of such as powder dust into the flow path 40 from the inner space of the inner member 12 where such as the differential screw 15 is arranged.

Separately, in this embodiment, the jacket is provided in the outer member 11, it is not limited to this, the jacket can be provided in at least one of the outer member 11 and the inner member 12. The jacket is not always needed to be provided in neither the outer member 11 nor the inner member 12.

In addition, in this embodiment, the inner peripheral surface 16 of the outer member 11 and the outer peripheral surface 17 of the inner member 12, which compartmentalize the flow path 40, do not have the horizontal planes having possibility which the fluid to be processed circulating the flow path 40 may accumulate. However, it is limited to this.

In addition, in this embodiment, the clearance adjusting unit 13 is configured with the fixing member 14 fixed to the outer member 11 and the differential screw 15 attached to the fixing member 14 and the inner member 12. It is not limited to this, various configurations can be applied as the clearance adjusting unit 13, which can adjust the clearance distance L by relatively moving the outer member 11 and the inner member 12 in the vertical direction.

In addition, in this embodiment, the multiple inflow openings 21 are connected to the respectively different pressure feeding systems, it is limited to this, for example, both the first inflow opening 21a and the second inflow opening 21b can be connected to the same pressure feeding system.

In addition, in this embodiment, the multiple inflow openings 21 are provided on the middle of processing region 40a, by being provided on the tapered inner peripheral surface 16b. it is not limited to this, the multiple inflow openings 21 can be arranged on the upper stream side than the processing region 40a. For example, in case that the upper stream region situated on upper stream side than the tapered inner peripheral surface 16b had been provided in the inner peripheral surface 16 of the outer member 11, the multiple inflow openings 21 can be provided on the upper stream region, or the multiple inflow openings 21 can be provided on both the upper stream region and the middle of the processing region 40a.

Next, second embodiment of this invention will be explained with reference to drawings. A microreactor 50 is different from first embodiment in the point that a downsized region 70b is provided just before the processing region 70c of the flow path 70. Separately, regarding the same configuration as first embodiment, the explanation will be omitted with placing the same numerical reference.

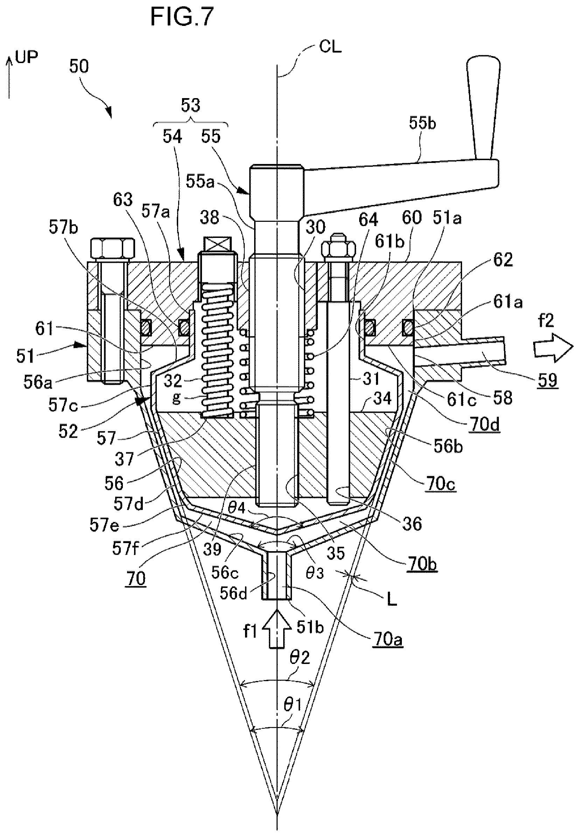

FIG.7 is an axial cross-sectional view of the microreactor according to second embodiment of the present invention.

As shown in FIG.7, the microreactor 50 according to this invention comprises an outer member 51 formed with tubular-shape extending in the predetermined direction (in this embodiment, vertical direction), an inner member 52 arranged inside in diametrical direction of the outer member 51, and a clearance adjusting unit 53 which can relatively move the outer member 51 and the inner member 52 in the vertical direction. The clearance adjusting unit 53 comprises a fixing member 54 fixed to the outer member 51 and a differential screw 55 attached to the fixing member 54 and the inner member 52.

The outer member 51 and the inner member 52 are coaxially arranged so that the central axes CL thereof overlap each other. The gap (space) is provided between the inner periphery surface 56 of the outer member 51 and the outer periphery surface 57 of the inner member 52, this gap functions as a flow path 70 through which the fluid to be processed circulates. The flow path 70 allows the circulation of the fluid to be processed from below (one side of predetermined direction) to above (another side of predetermined direction). Separately, unless otherwise noted, the structure of the microreactor 50 is explained, which is in using state.

The outer member 51 is formed with tubular-shape, of which central axis CL is extending in the vertical direction. The outer member 51 comprises an upper end opening 51a on the upper end thereof, a lower end opening 51b on the lower end thereof, and an inner peripheral surface 56 continuously extending from the upper end opening 51a to the lower end opening 51b. The upper end opening 51a and the lower end opening 51b are arranged so as to be concentric with the central axis CL. The upper end opening 51a of the outer member 51 functions as an insertion opening for inserting the inner member 52 into inside of outer member 51. The lower end opening 51b of the outer member 51 functions as the inflow opening for the fluid to be processed toward the flow path 70. That is, the microreactor 50 of this embodiment comprises one inflow opening (the lower end opening 51b) for the fluid to be processed.

The inner peripheral surface 56 of the outer member 51 compartmentalizes the inner space inward. In this embodiment, the inner peripheral surface 56 of the outer member 51 comprises four inner peripheral surfaces in the different regions disposed in the vertical direction. Four inner peripheral surfaces are, in order from above, a first tubular-shaped inner peripheral surface 56a, a first tapered inner peripheral surface (tapered inner peripheral surface) 56b, a second tapered inner peripheral surface 56c, a second tubular-shaped inner peripheral surface 56d. The lower end region of the first tubular-shaped inner peripheral surface 56a of the outer member 51, the first tapered inner peripheral surface 56b, the second tapered inner peripheral surface 56c, and the second tubular-shaped inner peripheral surface 56d compartmentalize outside in diametrical direction of the flow path 70. Separately, in this embodiment, the inner peripheral surface 56 is assumed as the inner peripheral surface 56 which comprises the first tubular-shaped inner peripheral surface 56a, the first tapered inner peripheral surface 56b, the second tapered inner peripheral surface 56c, and the second tubular-shaped inner peripheral surface 56d. it is not limited to this, the inner peripheral surface 56 should be employed, which comprises the first tapered inner peripheral surface(taper-shape inner peripheral surface) 56b at least in one part region thereof.

The first tubular-shaped inner peripheral surface 56b of the outer member 51 is formed with tubular-shape, extending toward below from the upper end opening 51a. The upper region of the first tubular-shaped inner peripheral surface 56a is facing to an outer peripheral surface 61a of an insertion part 61 in the fixing member 54, the insertion part 61 is described below. The lower region of the first tubular-shaped inner peripheral surface 56a compartmentalizes outside in diametrical direction of the space (an outflow region 70d described below) where such as the fluid to be processed is existing, which is before flowing out from the flow path 70. On the lower region of the first tubular-shaped inner peripheral surface 56a, an outflow opening 58 is formed, which is for making such as the fluid to be processed to flow out from the flow path 70. An outflow path 59 is extending from the outflow opening 58, which is for making the fluid to be processed to flow out from the flow path 70.

The first tapered inner peripheral surface 56b of the outer member 51 is the inner peripheral surface formed with taper-shape (conical shape), is extending toward below from the lower end of the first tubular-shaped inner peripheral surface 56a.the first tapered inner peripheral surface 56a is formed with taper-shape tapering off as getting downward from upward. The tubular-shaped inner peripheral surface 16b compartmentalizes outside in diametrical direction of the space (a processing region 70c described below) where the fluid to be processed can be processed. As shown in FIG.7, the position becoming the apex of the taper of the first tapered inner peripheral surface 56b is situated on the central axis CL. The apex angle *θ*1 of the taper of the first tapered inner peripheral surface 56b is set to 5 degrees or more, and 120 degrees or less. Separately, the apex angle *θ*1 of the taper of the tapered inner peripheral surface 16b is preferably 10 degrees or more and 90 degrees or less, further preferably 15 degrees or more and 55 degrees or less.

The second tapered inner peripheral surface 56c of the outer member 51 is the inner peripheral surface, is extending toward below from the lower end of the first tapered inner peripheral surface 56b. The second tapered inner peripheral surface 56c is formed with the taper-shape tapering off as getting downward from upward. The second tapered inner peripheral surface 56c, as shown in FIG.7, in axial cross section, compartmentalizes outside in diametrical direction of space (the downsized region 70b described below)) where width of flow path 70 is getting narrow as getting upward. The position (illustration is omitted) being the axial part of taper of the second tapered inner peripheral surface 56c is situated on the central axis CL. The apex angle *θ*3 of taper of the second tapered inner peripheral surface 56c is set to be larger than the apex angle *θ*1 of taper of the first tapered inner peripheral surface 56b (*θ*3> *θ*1).

The second tubular-shaped inner peripheral surface 56d of the outer member 51 is formed with tubular-shape, is continuously extending from the lower end of the second tapered inner peripheral surface 56c toward the lower end opening 51b which is in lower. The second tubular-shaped inner peripheral surface 56d compartmentalizes outside in diametrical direction of the region (the inflow region 70a described below) where the fluid to be processed firstly flows in, which is in the flow path 70.

Separately, same as first embodiment, the jacket(space) can be provided, which can circulate another fluid for temperature adjustment of the fluid to be processed being in the flow path 70.

The fixing member 54 of the clearance adjusting unit 53 comprises a cover part 60 which covers the upper end opening 51a of the outer member 51, and the tubular-shaped insertion part 61 which is inserted into the upper end opening 51a of the outer member 51 from upper side. The fixing member 54 is fixed to the outer member 51(for example, fixed with fastening).

The cover part 60 of the fixing member 54 is formed with larger diameter than that of the upper end opening 51a of the outer member 51. On the predetermined position (in this embodiment, the middle part of the cover part 60 with the central axis CL as the center), which is inside in diametrical direction of the tubular-shaped insertion part 61 described below in the cover part 60, a through hole is formed, which is going through in the vertical direction (axial direction). On the inner peripheral surface of the through hole, the female screw part 30 is formed. On the different position from the female screw part 30 on the cover part 60, where is inside in diametrical direction of the tubular-shaped insertion part 61, the pin 31 is fixed for stopping rotation extending along to the axial direction. The spring 32 which restricts the movement of the inner member 52 due to backlash of the differential screw 55 described below, is fixed in different position from the through hole of female screw part 30 and the pin 31, where are inside of the tubular-shaped insertion part 61 in the cover part 60, The guiding axis g for guidance is inserted into inside in diametrical direction of the spring 32, this guiding axis g restricts transformation of the spring 32 in the direction crossing with the vertical direction.

The tubular-shaped insertion part 61 of the fixing member 54 comprises the outer peripheral surface 61a which approaches to, or contacts with the upper region of the first tubular-shaped inner peripheral surface 56a of the outer member 51 while being opposed to, the inner peripheral surface 61b supporting the inner member 52 so that the inner member 52 can be moved, and the lower plane 61c compartmentalizing upper side of the flow path 70.

The outer peripheral surface 61a of the insertion part 61 is formed with cross-sectional circular-shape having slightly smaller diameter than that of the first tubular-shaped inner peripheral surface 56a of the outer member 51, is opposed to the first tubular-shaped inner peripheral surface 56a from inside thereof in diametrical direction. Between the outer peripheral surface 61a of the insertion part 61 and the first tubular-shaped inner peripheral surface 56a of the outer member 51, a sealing member 62(for example, O-ring) is provided. The sealing member 62 is provided in the entire peripheral region between the outer peripheral surface 61a of the insertion part 61 and the first tubular-shaped inner peripheral surface 56a of the outer member 51, seals between the outer peripheral surface 61a of the insertion part 61 and the first tubular-shaped inner peripheral surface 56a of the outer member 51, restricts upward outflow of the fluid to be processed from the flow path 70.

The inner peripheral surface 61b of the insertion part 61 is formed with cross-sectional circular-shape, is opposed to the outer peripheral surface 57 of upper end part of the inner member 52 from outside thereof in diametrical direction. Between the inner peripheral surface 61b of the insertion part 61 and the outer peripheral surface 57 of the inner member 52, a sealing member 63(for example, O-ring) is provided. The sealing member 63 is provided in the entire peripheral region between the inner peripheral surface 61b of the insertion part 61 and the outer peripheral surface 57 of the inner member 52, seals between the inner peripheral surface 61b of the insertion part 61 and the outer peripheral surface 57 of the inner member 52, restricts the upward outflow of the fluid to be processed from the flow path 70.

The inner member 52 is arranged inside in diametrical direction of the outer member 51 (inner space of the outer member 51), is supported to the fixing member 54 so that the inner member 52 can be slid and moved in vertical direction. That is, the inner member 52 can relatively move relative to the outer member 51 in the vertical direction (axial direction) via the fixing member 54. In this embodiment, the inner member 52 is inserted into the inner space of the outer member 51 from the upper end opening 51a of the outer member 51 in the state being supported by the fixing member 54. The inner member 52 comprises the outer peripheral surface 57 compartmentalizing the flow path 70 between the inner peripheral surface 56 of the outer member 51.

The inner member 52 of this embodiment is formed with bottomed tubular-shape opening upward. In the inner space of inner member 52, the supported part 34 supported to the differential screw 55 is provided. In the supported part 34, same as first embodiment, the female screw part 35, the pin insertion hole 36, and the spring supporting part 37 are formed. The relative rotation of the outer member 51 and the inner member 52 is restricted by the pin 31 which is inserted through the pin insertion hole 36 of the fixing member 54.

In this embodiment, the spring 64 is arranged between the peripheral upper face of the female screw part 35 of the supported part 34 in the inner member 52 and the peripheral lower face of the female screw part 30 of the cover part 60 in the fixing member 54. The spring 64 is a spiral spring extending in the vertical direction, can elastically transform in the vertical direction. Through the inner diametrical part of the spring 64, an axis part 55a described below of the differential screw 55 is inserted. The spring 64 is restricted from transforming in the direction crossing with the vertical direction by the axis part 55a of the differential screw 55. The spring 64 in using state is arranged between the supported part 34 of the inner member 52 and the cover part 60 of the fixing member 54, applies force to the inner member 52 downward. Due to this, the movement of the inner member 52 relative to the fixing member 54 and the outer member 51 in the vertical direction due to backlash of the differential screw 55, is restricted. Separately, the inner space of the inner member 52 can function as a jacket where another fluid for temperature adjustment of the fluid to be processed in the flow path 70 can be circulated.

The outer peripheral surface 57 of the inner member 52 is the outer peripheral surface which compartmentalizes inside in diametrical direction of the flow path 70, in this embodiment, comprises six outer peripheral surfaces in the different regions disposed in the vertical direction. The six outer peripheral surfaces are, in order from above, a first tubular-shaped outer peripheral surface 57a, a first tapered outer peripheral surface 57b, a second tubular-shaped outer peripheral surface 57c, a second tapered outer peripheral surface (tapered plane) 57d, a third tapered outer peripheral surface 57e, a fourth tapered outer peripheral surface 57f. That is, the inner member 52 comprises the second tapered outer peripheral surface (tapered plane) 57d on at least one part region of the outer peripheral surface 57. The lower region of the first tubular-shaped outer peripheral surface 57a of the inner member 52, the first tapered outer peripheral surface 57b, the second tubular-shaped outer peripheral surface 57c, the second tapered outer peripheral surface (tapered plane) 57d, the third tapered outer peripheral surface 57e, and the fourth tapered outer peripheral surface 57f compartmentalize inside in diametrical direction of the flow path 70. Separately, in this embodiment, the outer peripheral surface 57 of the inner member 52 is assumed as the outer peripheral surface comprising the first tubular-shaped outer peripheral surface 57a, the first tapered outer peripheral surface 57b, the second tubular-shaped outer peripheral surface 57c, the second tapered outer peripheral surface (tapered plane) 57d, the third tapered outer peripheral surface 57e, and the fourth tapered outer peripheral surface 57f. However, it is not limited to this, the outer peripheral surface 57 should be employed, which comprises the second tapered outer peripheral surface (tapered outer peripheral surface) 57d on at least one part region.

The first tubular-shaped outer peripheral surface 57a of the inner member 52 is formed with tubular- shape extending in the vertical direction, is provided in the upper end part of the inner member 52. The upper region of the first tubular-shaped outer peripheral surface 57a approaches to or contacts with the inner peripheral surface 61b of the insertion part 61 of the inner member 54 in the state being opposed to the inner peripheral surface 61b. The seal member 63 seals between the upper region of the first tubular-shaped outer peripheral surface 57a and the inner peripheral surface 61b of the insertion part 61 of the inner member 54. The lower region of the tubular-shaped outer peripheral surface 57a is arranged in the position estranged toward inside in diametrical direction from lower region of the first tubular-shaped inner peripheral surface 56a of the outer member 51. The lower region of the first tubular-shaped outer peripheral surface 57a is opposed to the first tubular-shaped inner peripheral surface 56a of the outer member 51 from inside thereof in diametrical direction. The lower region of the first tubular-shaped outer peripheral surface 57a compartmentalizes inside of the space (outflow region 70d described below) in diametrical direction, where such as fluid to be processed is existing, which is before flowing out from the flow path 70.

The first tapered outer peripheral surface 57b of the inner member 52 is formed with taper-shape (conical shape), is extending toward lower from the lower end of the first tubular-shaped outer peripheral surface 57a. The first tapered outer peripheral surface 57b is formed with taper-shape tapering as getting upper from lower. That is, the first tapered outer peripheral surface 57b is extending toward lower so that the diameter thereof is getting wide from the lower end of the first tubular-shaped outer peripheral surface 57a. The position (illustration is omitted) being the apex part of taper of the first tapered outer peripheral surface 57b is situated on the central axis CL. The first tapered outer peripheral surface 57b compartmentalizes inside of the space (outflow region 70c described below) in diametrical direction, where such as fluid to be processed is existing, which is before flowing out from the flow path 70.

The second tubular-shaped outer peripheral surface 57c of the inner member 12 is formed with tubular-shape extending in the vertical direction, is extending downward from the lower end of the first tapered outer peripheral surface 57b. That is, the second tubular-shaped outer peripheral surface 57c is formed with larger diameter than the first tubular-shaped outer peripheral surface 57a. the second tubular-shaped outer peripheral surface 57c is arranged in the estranged position inside in diametrical direction from the lower part region of the first tubular-shaped inner peripheral surface 56a of the outer member 51 and the upper end part region of the first tapered inner peripheral surface 56b, is opposed to the both regions from inside thereof in diametrical direction. The second tubular-shaped outer peripheral surface 57c compartmentalizes inside of space (outflow region 70d described below) in diametrical direction, where such as fluid to be processed is existing, which is before flowing out from the flow path 70.

The second tapered outer peripheral surface 57d of the inner member 52 is the outer peripheral surface formed with taper-shape (conical shape), is extending downward from the lower end of the second tubular-shaped outer peripheral surface 57c. The second tapered outer peripheral surface 57d is opposed to the first tapered inner peripheral surface 56b of the outer member 51 in the state being estranged from the first tapered inner peripheral surface 56b toward inside thereof in diametrical direction. In this embodiment, the second tapered outer peripheral surface 57d is formed with taper-shape tapering off as getting lower from upper. Between the second tapered outer peripheral surface 57d and the first tapered inner peripheral surface 56d, the space (processing region 70c described below) is compartmentalized, where fluid to be processed can be processed. That is, the second tapered outer peripheral surface 57d compartmentalizes outside, in diametrical direction, of the processing region 70c, where fluid to be processed can be processed. As shown in FIG.7, the position (illustration is omitted) being the apex part of taper of the second tapered outer peripheral surface 57d is situated on the central axis CL. The apex angle *θ*2 of the taper of the second tapered outer peripheral surface 57d is as same as the apex angle *θ*1, is set to be 5 degrees or more and 120 degrees or less. In this way, apex angle *θ*1, *θ*2 of tapers of the first tapered inner peripheral surface 56b and the second tapered outer peripheral surface 57d are set to same angles each other of 5 degrees or more and 120 degrees or less. Separately, apex angle *θ*1 of taper of the second tapered outer peripheral surface 57d is preferably 10 degrees or more and 90 degrees or less same as apex angle *θ*1 of taper of the first tapered inner peripheral surface 56b, more preferably 15 degrees or more and 55 degrees or less.

The third tapered outer peripheral surface 57e of the inner member 52 is the outer peripheral surface formed with taper-shape (conical shape), is extending downward from the lower end of the second tapered outer peripheral surface 57d. The third tapered outer peripheral surface 57e is formed with taper-shape tapering off as getting lower from upper. The third tapered outer peripheral surface 57e is, as shown in FIG.7, in axial cross section, compartmentalizes inside in diametrical direction of the space (the downsized region 70b described below) of which width of the flow path 70 is getting narrow as getting upward. The position (illustration is omitted) being apex angle of taper of the third tapered outer peripheral surface 57e is situated on central axis CL. The apex angle of the third tapered outer peripheral surface 57e is set to be larger than the apex angle *θ*2 of the taper of the second tapered outer peripheral surface 57d.

The fourth tapered outer peripheral surface 57f of the inner member 52 is the outer peripheral surface formed with taper-shape (conical shape), is extending from lower end of the third tapered outer peripheral surface 57e to the lower end of the inner member 52. The fourth tapered outer peripheral surface 57f is formed with taper-shape tapering off as getting lower from upper. The fourth tapered outer peripheral surface 57f is, as shown in FIG.7, in axial cross section, compartmentalizes inside in diametrical direction of the space (the downsized region 70b described below) of which width of the flow path 70 is getting narrow as getting upward. The position (approximately same position as lower end of the inner member 52) being apex angle of taper of the fourth tapered outer peripheral surface 57f is situated on central axis CL. The apex angle *θ*4 of the fourth tapered outer peripheral surface 57f is set to be smaller than the apex angle *θ*3 of the taper of the second tapered inner peripheral surface 56c (*θ*4 < *θ*3).

The differential screw 55 of the clearance adjusting unit 53 is the member where the estrangement distance L (hereinafter, it may be simply referred to "clearance distance L") between the first tapered inner peripheral surface 56b and the second tapered outer peripheral surface 57d can be adjusted, by sliding and moving the inner member 52 in the vertical direction relative to the fixing member 54. That is, the clearance adjusting unit 53 with the fixing member 54 and the differential screw 55 and adjust the clearance distance L between the first tapered inner peripheral surface 56b and the second tapered outer peripheral surface 57d by relatively moving the outer member 51 and the inner member 52 in the vertical direction. The differential screw 55 integrally comprises an axis part 55a and a handle part 55b.

The axis part 55a is linearly extending in axial direction, is inserted through the through hole where the female screw part 30 of the fixing member 54 is formed, the thorough hoke where the female screw part 35 of the inner member 52 is formed, and the inner diametrical part of the spring 64. The upper end of the axis part 55a is projecting upward from the fixing member 54. The axis part 55a comprises a first male screw part 38 screwing with the female screw part 30 of the fixing member 54, a second male screw part 39 screwing with the female screw part 35 of the inner member 52. Separately, in this embodiment, the female screw part 35 is provided in the supported part 34 of the inner member 52, while the second male screw part 39 is provided in the differential screw 35, it is not limited to this. For example, instead of the female screw part 35, the male screw part can be provided in the supported part 34 of the inner member 52, while the female screw part screwing with the male screw part can be provided in the differential screw 55, instead of the second male screw part 39.

The handle part 55b of the differential screw 55 is the operational part of the differential screw 55, is extending toward outside in diametrical direction from the upper end part of the axial part 55a. The user holds the handle part 55b and rotate the axial part 55a, thereby the inner member 52 can be slid and moved in the axial direction relative to the outer member 51.

Next, the flow path 70 will be explained, where is compartmentalized between the inner peripheral surface 56 of the outer member 52 and the outer peripheral surface 57 of the inner member 52.

**In** the state that the microreactor 50 has been assembled, the flow path 70 where fluid to be processed circulates from lower side to upper side is compartmentalized between the inner peripheral surface 56 of the outer member 51 and the outer peripheral surface 57 of the inner member 52. The flow path 70 in this embodiment comprises four regions. The four regions of flow path 70 are, in order from below, the inflow region 70a, the downsized region 70b, the processing region 70c, the outflow region 70d.

The inflow region 70a of the circulation 70 is the space where fluid to be processed which had been flowed into the flow path 70 firstly circulates, in the state that the central axis CL is assumed as center, the inflow region 70a is extending upward from the lower end opening 51b of the outer member 51. The fluid to be processed which had been pressure fed by the pressure feeding system same as above mentioned first embodiment, is flowed upward from the lower end opening 51b into the inflow region 70a.

The downsized region 70b of the flow path 70 is the region of which diameter widens toward upper from the end part of inflow region 70a. The width of the downsized region 70b (the estrangement distance between the outer peripheral surface 57 of the inner member 52 and the inner peripheral surface 56 of the outer member 51 in axial cross section) is getting narrow as getting above.

The processing region 70c of the flow path 70 is microchannel, of which clearance distance L is slight, can process the fluid to be processed. The processing region 70c is compartmentalized between the second tapered outer peripheral surface 57d of the inner member 52 and the first tapered inner peripheral surface 56b of the outer member 51. The diameter of sectional plane perpendicular to diametric direction in the processing region 70c of this embodiment is enlarging as getting above from below. In addition, the clearance distance L of the processing region 70c of this embodiment is constant across from below to above.

The clearance distance L of processing region 70c in using state of microreactor 50 is preferably 0.1 µm or more and 3mm or less. Setting clearance distance L within the range enables to set the slight flow path where effective process of fluid to be processed can be performed.

The outflow region 70d of the flow path 70 is space where such as fluid to be processed flows in, which had passed through processing region 70c. The outflow region 70d is situated above of processing region 70c, is communicating with processing region 70c, the above thereof is compartmentalized by lower plane 61c of the fixing member 54. The estrangement distance between the outer peripheral surface 57 of inner member 52 and the inner peripheral surface 56 of outer member 51 in the outflow region 70d is set to be wider than clearance distance L of the processing region 70c. The outflow opening 58 is communicating with the outflow region 70d, processed object processed by the microreactor 50 is flowed out toward outside from outflow region 70d via the outflow opening 58 and the outflow opening 59.

The outer peripheral surface 57 of inner member 52 and the inner peripheral surface 56 of outer member 51, which compartmentalize the flow path 70, do not have horizontal planes which have possibility that such as fluid to be processed may accumulate, in the state axial direction is assumed as vertical direction.

As material of the outer peripheral surface 57 of inner member 52 and the inner peripheral surface 56 of outer member 51, same as first embodiment, such as metals can be properly selected according to the kind of fluid to be processed. In addition, the outer peripheral surface 57 of inner member 52 and the inner peripheral surface 56 of outer member 51, which compartmentalize the flow path 70, is preferably coated with corrosion-resistant materials.

Next, flow of fluid to be processed in case of processing in the microreactor 50 will be explained.

As shown with hollow arrow f1 in FIG.7, the fluid to be processed is, at first, pressure fed from the pressure feeding system, then flows upward toward the inflow region 70a of flow path 70 along to axial direction from the lower end opening 51b of outer member 51 in the microreactor 50. The fluid to be processed which had flowed in into the inflow region 70a flows into the downsized region 70b being above, in the downsized region 70b, fluid to be processed ascends along to the fourth tapered outer peripheral surface 57f of inner member 52 with widening toward outside in diametrical direction. In the downsized region 70b, the width of downsized region 70b is getting narrow as getting upward, and the diameter of downsized region 70b is getting large as getting upward, thereby the fluid to be processed flows into the processing region 70c being upper with gradually changing flow from axial direction to circumferential direction. The fluid to be processed which had flowed into processing region 70c is, by the clearance distance L which had been properly set, while flow in circumstantial direction is maintained, is effectively applied force and processed in the microchannel. Such as fluid to be processed which had been processed in the processing region 70c flows in into the outflow region 70d being upper. As shown with hollow arrow f2 in FIG.7, such as fluid to be processed which had been flowed in into outflow region 70d flows out toward outside of the microreactor 50 as processed object from the outflow opening 58 of outflow region 70d, then for example, is stored in the storage container.

Separately, the method for use in case of setting microreactor 50 to using state, and method for use in case of washing or sterilization are same as first embodiment, explanation will be omitted.

In the microreactor 50 configured like above, the relative rotation between the outer member 51 and the inner member 52 is restricted, and the clearance adjusting unit 53 enabling to adjust clearance distance L is provided. Therefore, like as first embodiment, it is possible to provide the microreactor 50 which enables to reduce the length of the flow path 70 for the fluid to be processed (object to be processed) and processing time, of which structure is simple, of which number of components is low, and of which producing cost is reduced.

**In** addition, the inflow opening of fluid to be processed toward flow path 70 is one spot where is the lower end opening 50b of outer member 51, thereby enabling to be simple structure.

In addition, the downsized region 70b is provided just before the processing region 70c of the flow path 70. Therefore, the downsized region 70b can function as header for providing fluid to be processed to processing region 70c, can restrict the occurrence of void and cavitation in processing region 70c.

In addition, the spring 64 is provided between the supported part 34 of the inner member 52 and the cover part 60 of fixing member 54, the axis part 55a of differential screw 55 is inserted through the inner diametrical part of spring 64. Therefore, the spring 64 surrounding axis part 55a of differential screw 55 also can effectively restrict movement of inner member 52 by backlash due to differential screw 55.

Separately, one lower end opening 51b is provided as the inflow opening of fluid to be processed, it is not limited to this, the inflow openings for fluid to be processed can be provided in multiple spots.

In addition, in this embodiment, the outer peripheral surface 57 of the inner member 52 and the inner peripheral surface 56 of the outer member 51, which compartmentalize the flow path, do not have horizontal parts having possibility which such as fluid to be processed circulating through the flow path 70 may accumulate. However, it is not limited to this.

In addition, in this embodiment, the clearance adjusting unit 53 is configured with the fixing member 54 fixed to outer member 51, and the differential screw 55 attached to the fixing member 54 and the inner member 52. However, it is not limited to this, various configurations can be applied as the clearance adjusting unit 53, which enable to adjust clearance distance L by relatively moving the outer member 51 and inner member 52 in vertical direction.

### [List of Reference Signs]

10, 50 microreactor
11, 51 outer member
12, 52 inner member
13, 53 clearance adjusting unit
14, 54 fixing member
15, 55 differential screw
16, 66 inner peripheral surface
16b tapered inner peripheral surface
17, 57 outer peripheral surface
17c tapered outer peripheral surface
21 multiple inflow openings (multiple inflow openings for fluid to be processed)
25 jacket
40, 70 flow path
40a, 70c processing region
56b first tapered inner peripheral surface (tapered inner peripheral surface)
57d second tapered outer peripheral surface (tapered outer peripheral surface) L clearance distance
S1, S2, S3 pressure feeding system

## Claims

1. A microreactor comprising:
a tubular-shaped outer member comprising a tapered inner peripheral surface at least in one part region of an inner peripheral surface, the outer member being extending in the predetermined direction,
an inner member comprising a tapered outer peripheral surface facing to the tapered inner peripheral surface at least in one part region of an outer peripheral surface, the inner member being arranged inside of the outer member in diametrical direction, and
a clearance adjusting unit which enables adjustment of clearance distance between the tapered inner peripheral surface and the tapered outer peripheral surface by relatively moving the outer member and the inner member in the predetermined direction; wherein
a relative rotation between the outer member and the inner member is restricted,
a flow path is compartmentalized between the inner peripheral surface of the outer member and the outer peripheral surface of the inner member, through which an object to be processed is circulating from one side of the predetermined direction to another side thereof,
a region compartmentalized in the flow path by the tapered inner peripheral surface and the tapered outer peripheral surface functions as the processing region processing the object to be processed, and
an apex angles of tapers of the tapered inner peripheral surface and the tapered outer peripheral surface are set to be the same angle each other, the apex angles are 5 degrees or more and 120 degrees or less.

2. The microreactor according to claim 1; wherein
the microreactor executes one process among reaction including biochemical reaction, crystallization, mixing, dissolving, and dispersing in the processing region of the flow path.

3. The microreactor according to claim 1 or 2; wherein
the tapered inner peripheral surface and the tapered outer peripheral surface are tapered tapering off from another side of the predetermined direction to the one side thereof.

4. The microreactor according to claim 1 or 2; further comprising
multiple inflow openings for the object to be processed allowing inflow of the object to be processed into the flow path; wherein
the multiple inflow openings for the object to be processed are arranged in more upstream side than the processing region in the flow path, or arranged in the middle of the processing region.

5. The microreactor according to claim 4; wherein
the multiple inflow openings for the object to be processed are respectively connected to different pressure feeding systems.

6. The microreactor according to claim 1 or 2; wherein
the clearance distance is 0.1µm or more and 3mm or less in using state in case of processing of the object to be processed

7. The microreactor according to claim 1 or 2; wherein
the clearance adjusting unit comprises,
a fixing member for supporting the inner member so that the inner member can slide and move in the predetermined direction, the fixing member is fixed to the outer member, and
a differential screw for sliding and moving the inner member relative to the fixing member in the predetermined direction.

8. The microreactor according to claim 1 or 2; wherein
the inner peripheral surface of the outer member and the outer peripheral surface of the inner member, which compartmentalize the flow path, do not have horizontal parts having possibility which the object to be processed circulating through the flow path may accumulate.

9. The microreactor according to claim 1 or 2; wherein
At least one of the outer member and the inner member comprises a jacket through which another fluid can circulate, the another fluid is for temperature adjustment of the object to be processed circulating through the flow path.

10. The microreactor according to claim 1 or 2; wherein
The inner peripheral surface of the outer member and the outer peripheral surface of the inner member, which compartmentalize the flow path, are coated with corrosion-resistant material.

11. The method for use of the microreactor using the microreactor according to claim 6;
wherein
in case of adjusting the clearance distance to using state, contacting the tapered inner peripheral surface and the tapered outer peripheral surface thereafter, estranging the tapered outer peripheral surface toward another side of the predetermined direction from the tapered inner peripheral surface to set to using state.
